# EUROPEAN PATENT APPLICATION

(11) **EP 1 361 305 A1**
(43) Date of publication of application: **12.11.2003**
(21) Application number: 01972513.4
(22) Date of filing: 26.09.2001
(51) Int. Cl.: D04B 27/32, H01L 41/09

(54) **JACQUARD DEVICE OF WARP KNITTING MACHINE**

(30) Priority: 27.09.2000 JP 2000293521; 28.09.2000 JP 2000295374
(71) Applicant: NIPPON MAYER CO., LTD., Fukui shi, Fukui 918-8522 (JP)
(72) Inventor: SUMIDA, Kenji, Nogi-cho Shimotsuga-gun, Tochigi 329-011 (JP); OTOBE, Yoshinori, c/o Nippon Mayer Ltd., Fukui-shi, Fukui 918-8522 (JP)
(74) Representative: Knoblauch, Andreas, Dr.-Ing.
(86) International application number: JP0108400
(87) International publication number: WO02027087

(57) **Abstract**

A jacquard device capable of facilitating the manufacture and knitting operation of a jacquard guide bar, simplifying the structure of the jacquard guide bar, and allowing the jacquard guide bar having a large number of reads to be installed in a warp knitting machine having, on the jacquard guide bar, jacquard segments formed of a plurality of piezoelectric device elements including a jacquard guide disposed parallel with each other, wherein control substrates (12) are formed integrally with a part of the plurality of jacquard segments (2) to connect in series to each other and to connect individually to the electrode terminals (9) and (10) of the piezoelectric device elements (5) including the piezoelectric device ceramics, and a displacement part (7) is distorted by the control and drive signals transferred to the control substrates (12) to displace the jacquard guide (8b) by a dimensional amount commensurate with a knitting machine gauge.

## Description

### [Technical Field]

The present invention relates to a jacquard apparatus in a warp knitting machine, of a piezoelectric displacement type, in which each jacquard guide is controlled separately with each other.

### [Background of the Invention]

The applicant has previously proposed a structure of a jacquard guide bar utilizing a piezoelectric displacement constituted by providing a piezoelectric transducer by omitting a harness cord in a jacquard apparatus of a warp knitting machine, which has been patented as Japanese Registered Patent No. 1770365. Thereafter, jacquard apparatus utilizing the basic patent have been proposed and disclosed in, for example, Japanese Registered Patent No. 2919773, JP-08(1996)-209510A (Japanese Patent Laid-Open No. 209510/1996) and the like.

The jacquard apparatus is provided with a piezoelectric transducer element attached with a jacquard guide having a warp feeding hole (warp guiding hole) at a front end portion thereof ; and such piezoelectric transducer elements are arranged in a row or rows, in correspondence with a number of pieces of needles of a warp knitting machine, and are fixedly attached to holder sections provided at a jacquard guide bar.

Normally, according to the piezoelectric element constituted by attaching the jacquard guide, for example, 16 pieces thereof are constituted as one unit or one segment; and a number of the segments (units) in accordance with an operational width of the warp knitting machine, are fixedly attached to the holder sections of the guide bar in parallel with a needle row. Depending on a gage of the needle row, 32 pieces of the piezoelectric transducer elements may constitute the one unit of the segment.

Further, control lead wires connected to connection electric terminals of the respective piezoelectric transducer elements of the respective segment, are bundled in a single piece of cable; and a tuck-in plug provided at an end portion of the cable is plugged in an attaching member having a control board in it, which member is fixed on a traverse horizontally suspended in a width direction of the knitting machine at above the guide bar.

Therefore, according to the jacquard apparatus having the above-described constitution, the harness cord is certainly eliminated; nevertheless, at a vicinity of a knitting portion of the knitting machine, there are still present the attaching member incorporating the control board and the cable connected to the attaching member; and an increase in a number of fabricating steps is unavoidable in fabricating the knitting machine. Further, in knitting, the presence of the attaching member and the cable makes knitting operation such as handling strings troublesome, makes installation of a number of sheets of the jacquard guide bars extremely difficult; and becoming a factor for deteriorating operability.

Hence, a first object of the invention is to resolve the above-described drawback; that is, the first object is to realize a warp knitting machine being installed with a number of sheets of jacquard guide bars, is to facilitate fabrication of the jacquard guide bar and knitting operation and is to simplify the structure of the jacquard guide bar, with respect to a jacquard apparatus of a piezoelectric displacement type.

Further, the piezoelectric transducer element is formed of piezoelectric ceramics adhered on both faces of a support plate; and thereby, a displacement is caused in a desired direction at the jacquard guide by controlling application of electricity to the piezoelectric ceramics. Further, when electricity is applied to ceramics on one side in order to bring about a displacement of the jacquard guide, the ceramics is strained to be deflected by a piezoelectric effect and in accordance therewith, the support plate is bent to the one side. At this occasion, electricity is not applied to ceramics on other side. Further, in order to provide a displacement in other direction, the ceramics having been previously applied with electricity, is discharged to thereby release its deflection; and a deflection in an opposed direction is brought about by newly applying electricity to ceramics on the other side. Thereby, the displacement in the desired direction is brought about in the jacquard guide attached to the front-end portion.

However, according to the above-described jacquard apparatus of the piezoelectric displacement type, high voltage of 200V is usually required to be applied to the ceramics. depending on a system of controlling electricity; and therefore, there is always a concern of a hazard by electricity leakage. Further, a plurality of piezoelectric transducer elements are compactly arranged in the one unit or the one segment; and therefore, when a disability or disorder is brought about at a single one of the piezoelectric transducer elements as to be required to be replaced with new one, it is necessary to replace a whole of the one segment and to take time and labor.

Hence, it is a second object of the invention to resolve the above-described drawback; and the second object is to provide a jacquard apparatus of a piezoelectric displacement type capable of deflecting a piezoelectric transducer element sufficiently by relatively low voltage of, for example, about 40V; and, further preferably, is to enable attaching and detaching of each piezoelectric transducer element separately with other.

### [Disclosure of the Invention]

The invention is a jacquard apparatus for individually controlling a jacquard guide in a warp knitting machine and in order to resolve the above-described problem. The jacquard apparatus in awarp knitting machine comprising: piezoelectric actuators; jacquard segments, each of which has piezoelectric transducer elements arranged side by side, as each of the transducer elements has a jacquard guide having a string feed hole at one end of the jacquard guide; and a jacquard guide bar, on which a plurality of said jacquard segments are attached; said jacquard apparatus being characterized by comprising: controller boards that are connected with each other in serial, each being integrally incorporated in a portion of respective one of the jacquard segments, and each being electrically connected separately with other to electric terminals on respective ones of the piezoelectric transducer elements; wherein each of the piezoelectric transducer elements on the jacquard segments, which are arranged side by side, is deflectable in response of a controlling and driving signal transmitted to respective one of said controller boards.

Thereby, the controlling and driving signals to the control boards can serially be transferred, that is, the controlling and driving signals can successively be transferred to contiguous ones of the control boards; and therefore, attaching members and cords can completely be eliminated from a vicinity of the knitting portion of a knitting machine. Therefore, knitting operation can preferably be carried out; and further, the structure of the jacquard bar is simplified; and therefore, there is eliminated a disturbance or obstacle due to arranging the jacquard guide bar.

The above-described apparatus may be constructed as such that, each of the jacquard segments, which is a unit formed of piezoelectric transducer elements arranged side by side with each other, is fixed on a mounting site on the jacquard guide bar as to be arranged contiguous with other in a longitudinal direction of the jacquard guide bar; and said jacquard segments being connected with each other through cables formed of bus lines, as input and output connectors on upper portions of the jacquard segments being connected by the cables.

Thereby, only a single piece of a cord to the respective jacquard guide bars will do, as a result, a number of sheets of the jacquard guide bars can be provided at the warp knitting machine.

Further, when the jacquard segment has a plurality of the piezoelectric transducer elements that are arranged side by side and are attached thereon by fitting separately with each other, the damaged or disabled jacquard guide is replaceable separately with other one.

Further, the piezoelectric transducer elements may constructed as such that said piezoelectric transducer element has a deflector section formed of piezoelectric ceramics on both sides thereof; and said piezoelectric ceramics on both sides being deliberately or proactively deformed simultaneously in a same direction, when electricity is applied to the piezoelectric ceramics on both side as to be polarized as heteropolar between said both sides. Thereby, a desired sufficient displacement can be brought about in the jacquard guide even by low conducted voltage.

In other wise, according to the invention, jacquard apparatus in a warp knitting machine is comprised of piezoelectric transducer elements, each of which has a piezoelectric actuator and a jacquard guide having a string feed hole at one end portion thereof; and the piezoelectric transducer elements being arranged on a jacquard guide bar as to match a row of knitting needles; said jacquard apparatus being characterized by said piezoelectric transducer elements that is comprised of; a displacing section formed of piezoelectric ceramics adhered on both faces of a thin supporter plate and provided with electrode (electric terminal) layers; a holder section secured on an end portion of the displacing section; and a guide section formed of a jacquard guide having a string-feeding hole at its end opposite to the displacing section; and said piezoelectric ceramics on both sides being deliberately deformed simultaneously in a same direction when electricity is applied to the piezoelectric ceramics on both side as to be polarized as heteropolar between said both sides; as thereby lapping of the jacquard guide being effected.

Thereby, by proactively deflecting simultaneously the piezoelectric ceramics arranged on the both sides, a desired sufficient displacement can be brought about in the jacquard guide even at low conducted voltage; a hazard by electricity leakage or the like can be prevented; and durability can be promoted.

Further, the above-described apparatus may be constructed as such that feeding of strings, which is based on a displacement of a front end of the guide, is enabled by applying a voltage in a range of 40V through 100V onto the piezoelectric transducer element, which has the jacquard guide. Thereby, electricity leakage from the piezoelectric transducer element applied with electricity is preventable; and therefore, the jacquard guide can preferably be operated and further, promotion of safety can also be achieved.

Further, the above-described apparatus may be constructed such that each of the piezoelectric transducer elements, which is fabricated separately with each other, has; an electric terminal integrally formed on the holder section at one end of the piezoelectric transducer element; and ridges on both side ends of the holder section as to be fitted in positioning grooves on detachably-mounting parts on the guide bar; thereby each of the jacquard guide is attachable and detachable separately with each other.

Thereby, positioning of the jacquard guide can accurately be carried out and further; the damaged jacquard guide can individually be interchanged.

### [Brief Description of the Drawings]

Fig. 1 shows a jacquard guide structure in a first embodiment of the invention-wise apparatus, which has a piezoelectric actuator, by a partially sectional side view.
Fig. 2 is a front view showing a manner in which a plurality of jacquard segments are attached on amounting part on a jacquard guide bar.
Fig. 3 is a perspective view showing a singled-out piezoelectric transducer element constituting a piezoelectric actuator.
Fig. 4 is an enlarged perspective view showing a portion where jacquard guides appear.
Fig. 5 is an explanatory view showing details of control and drive signal paths to the piezoelectric transducer element.
Fig. 6 is an explanatory view showing an outline of a control system in the invention-wise apparatus.
Fig. 7 shows a second embodiment of the invention-wise apparatus, which has a piezoelectric actuator, by a partially sectional side view.
Fig. 8 is a sketchy perspective view showing a structure of a displacing section in the piezoelectric transducer element of just-mentioned apparatus.
Fig. 9 is a full perspective view of the piezoelectric transducer element of the just-mentioned apparatus.
Fig. 10 is a front view showing one unit of a jacquard segment of the above-mentioned apparatus.
Fig. 11 is an enlarged sectional view, of a portion, taken along a line X-X on Fig. 10.
Fig. 12 is a circuit diagram showing a manner of controlling of electricity application onto the piezoelectric transducer element, in the invention-wise apparatus.

### [Best Mode for Carrying out the Invention]

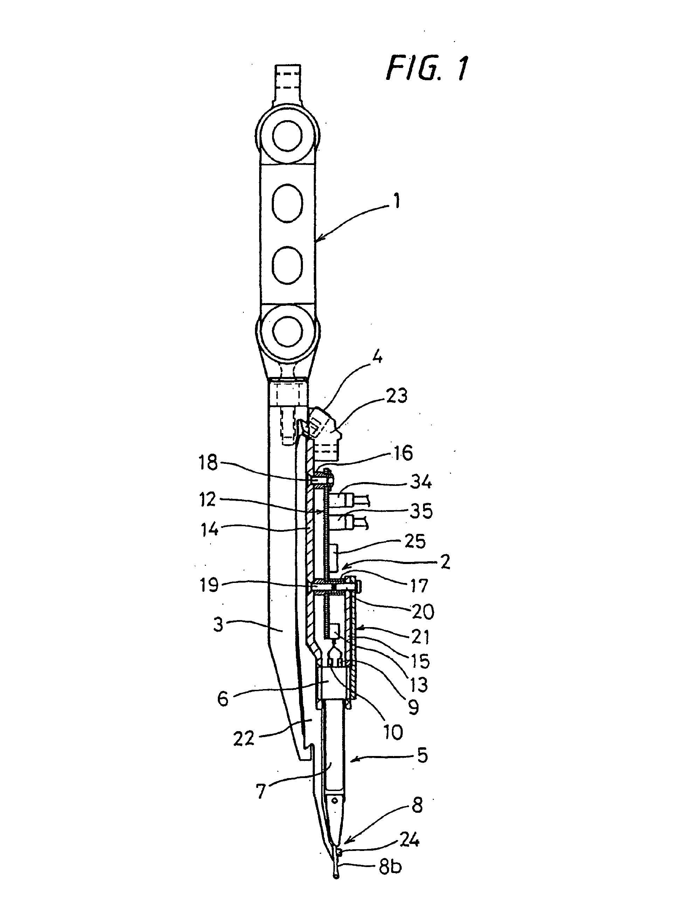

Next, an explanation will be given of a first embodiment of the invention-wise apparatus in reference to Fig. 1 through Fig. 6.

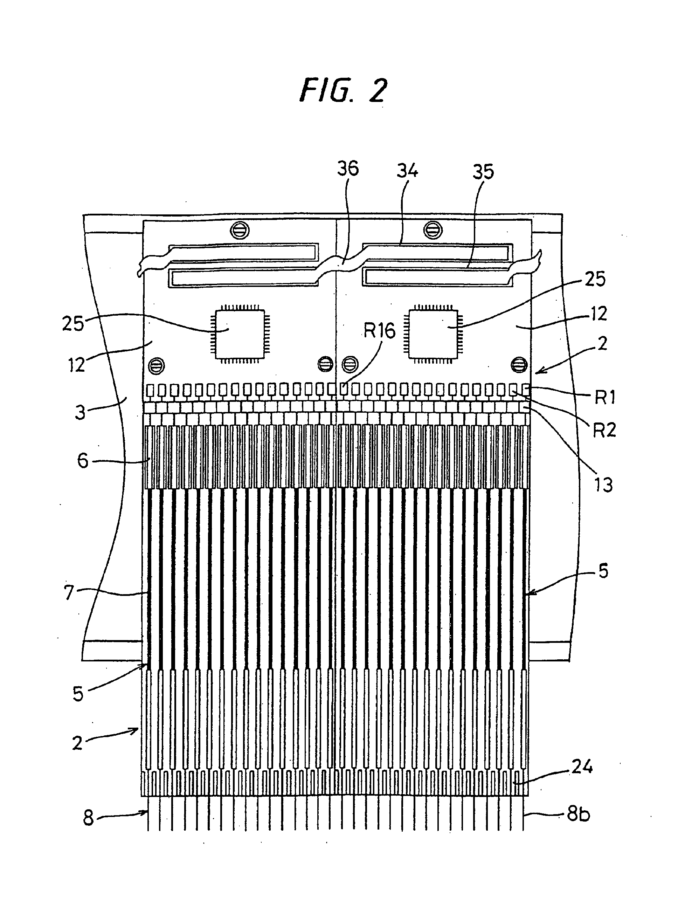

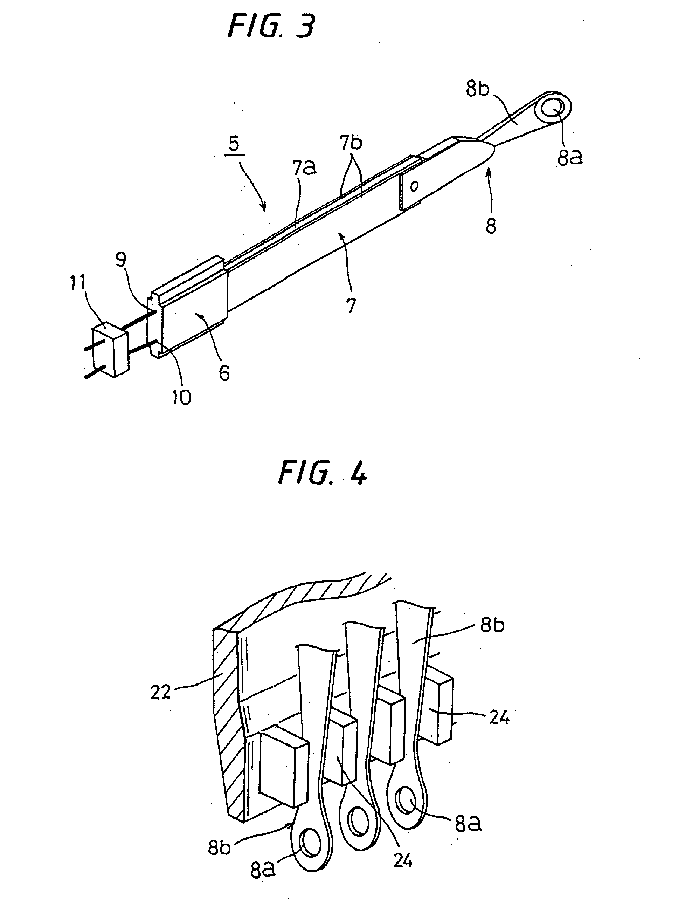

Fig. 1 shows a jacquard guide structure in a first embodiment of the invention-wise apparatus, which has a piezoelectric actuator, by a partially sectional side view; Fig. 2 shows a state in which a plurality of jacquard segments are attached on a mounting part on a jacquard guide bar; Fig. 3 shows a singled-out piezoelectric transducer element, which has been fittingly attached on a mounting part for the jacquard guide segments; and Fig. 4 shows a portion where jacquard guides appears.

In the drawings, numeral 1 designates a jacquard guide bar. Numeral 2 designates a jacquard segment. The jacquard segments are fixed by a screw 4 to a mounting part 3, which is disposed along one width-wise verge (mainly along a lower verge) of the jacquard guide bar 1 in its longitudinal direction.

As shown by Fig. 2, a plurality of pieces of the jacquard segments 2 are attached to the mounting part 3 on the jacquard guide bar 1 as to be arranged contiguous with other in the longitudinal direction along a needle row. Fig. 2 shows two pieces of the jacquard segments in an attached state where some members are omitted, in order to facilitate understanding of structure of the jacquard segment 2.

Numeral 5 designates a piezoelectric transducer element, which is comprised of a holder section 6, a displacing section 7 and a string guide section 8 as shown in Fig. 3.

The displacing section 7 is formed such that, on both faces of a support thin plate 7a, piezoelectric ceramics 7b, 7b coated with not-illustrated electrode (electric terminal) layer(s) is adhered.

The holder section 6 is fixedly provided to one end portion of the displacing section 7 by injection molding. The holder section 6 is integrally formed with an electric terminal 9 continuous to an end portion of the support thin plate 7a, as well as with an electric terminal 10 continuous to the electrode layers of the piezoelectric ceramics 7b, 7b, in an insulating state.

The guide section 8 is formed of a jacquard guide 8b, which has a string feed hole 8a for guiding a string at an end portion thereof, and which is attached to another end portion of the displacing section 7 on a side opposed to the holder section 6.

The above-described piezoelectric transducer element 5 functions as apiezoelectric actuator by following manner; when electricity is applied to the piezoelectric ceramics 7b, 7b, the ceramics 7b, 7b is strained by piezoelectric effect to deform the displacing section 7; and, being returned to original position when application of electricity is ceased. In this manner, the jacquard guide 8b is shifted by a dimension tantamount to a knitting machine gage, in a desired direction.

An explanation will be given as follows, of a structure of an apparatus including the jacquard segment 2, in reference to Fig. 1, Fig. 2, Fig. 3 and Fig. 4.

In one (unit) of the jacquard segments 2, 16 pieces of the piezoelectric transducer elements 5 are detachably attached as separately with each other, in correspondence with a gage of a not-illustrated needle row of a warp knitting machine. In other words, 16 pieces of the piezoelectric transducer elements 5 are arranged side-by-side in one (unit) of the jacquard segments 2. Depending on the gage of the knitting machine, 32 pieces of the piezoelectric transducer elements 5 may be arranged in the one unit of segments.

Numeral 11 designates a plug, one end of which is connected to the electric terminals 9 and 10, and other end of which is plugged in an output terminal 13 provided at a control board 12. The control board 12 is fixedly screwed by screws 18, 19 and 20, between holding plates 14 and 15, on which the piezoelectric transducer elements 5 are attached by fitting through spacers 16 and 17 therebetween. Numeral 21 designates a lid plate, which is provided on an outer side of the holding plate 15 and is fixedly attached to the holding plate 14 along with the holding plate 15 by the screw 20.

Numeral 22 designates an attaching frame, substantially an upper half portion of which is integrated to the holding plate 14 by adhering and is fixedly screwed to a holding member 23 at an upper end portion thereof. Further, at a lower end portion of the attaching frame 22, as shown to enlarge in Fig. 4, recessed or groove portions 24 are arranged side by side as cut outs arranged in a pitch tantamount to the knitting machine gage. The jacquard guide 8b can be displaced in the left and right direction within a groove width of the recessed or groove portion 24.

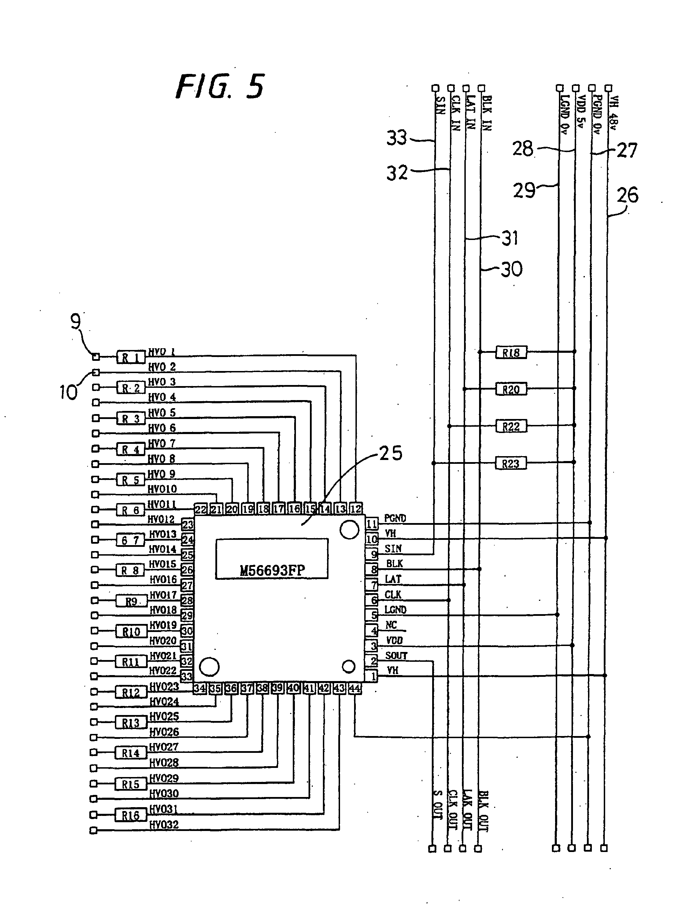

The control board 12 is mounted with an IC chip ("M56693FP" , a manufacture of Mitsubishi Electric Co.) 25 for carrying out signal processing for controlling and driving; and Fig. 5 shows detailed paths of the controlling and driving signals.

Notations R1 through R16 in Fig. 5 designate current limiting resistors, one sides of which are wired to the respective electric terminals 9 of 16 pieces of the respective piezoelectric transducer elements 5 and other sides of which are wired to respective terminals of the IC chip 25. Numerals 26 through 33 designate bus lines; numeral 26 designate a VH line for supplying high voltage (48V); numeral 27 designates a PGND line for high voltage ground (0V); line 28 designates a VDD line for supplying power source (5V) for control; numeral 29 designates an LGND line for control power source ground (0V); numeral 30 designates a BLK line for inputting and outputting an output permitting signal; numeral 31 designates an LAT line for inputting and outputting a latch input signal; numeral 32 designates a CLK line for inputting and outputting a clock signal; and numeral 33 designates an SIN line for inputting and outputting serial data; and each of these lines is connected to the corresponding IC chip 25. Notation NC designates an unused terminal. Further, notations R18, R20, R22 and R23 designate bus strengthening resistors respectively provided between line 28 and line 30, between line 28 and line 31, between line 28 and line 32 and between line 28 and line 33.

Numeral 34 designates a connector for power source and inputting signal; and numeral 35 designates a connector for power source and outputting signal. These connectors are arranged side by side at upper side of the control board 12; and as shown by Fig. 2, contiguous pairs of the control boards are connected by a cable 36 comprised of eight pieces of bus lines.

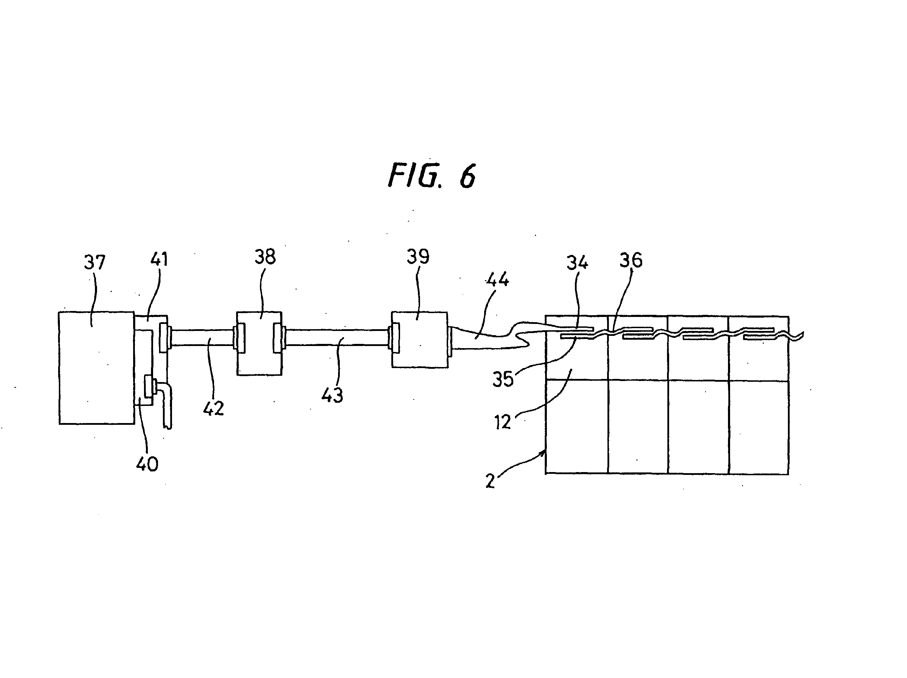

The above described is the constitution of the first embodiment of the invention-wise apparatus; and an explanation will be given of an embodiment of the control system in reference to the control system diagram of Fig. 6, as follows.

Numeral 37 designates a control computer; numeral 38 designates a line driver board; and numeral 39 designates a receiving board. The control computer 37 is connected with a data input card 4 that is for inputting signals of starting of overlapping and underlapping in knitting, interface signals with the knitting machine and the like; and the control computer 37 is also connected with a data output card 41 for outputting various output data from the control computer 37. The data output card 41 and the line driver board 38, and the line driver board 38 and the receiving board 39 are respectively connected by differential lines 42 and 43. The receiving board 39 is attached to a portion of a machine frame of the warp knitting machine on one end side of the jacquard guide bar and is connected to the connector 34, which is for inputting signals into a leftist one of the jacquard segments 2 in Fig. 6, through a cable 44 comprised of eight pieces of the bus lines 26 through 33. Pattern data are formed separately by a pattern forming system (not illustrated) and are inputted to the control computer 37 from a record medium of a floppy disk or the like.

As described above, the every jacquard segments 2 are arranged side by side on the mounting part 3 of the jacquard guide bar 1. The control boards 12 of the jacquard segments 2 are connected by the cables 36 in longitudinal direction of the jacquard guide bar 1; and thus, each of the controlling and driving signals is transmitted serially, that is, the each signal is transmitted successively to next and contiguous one of the control boards 12.

Therefore, at a periphery of the jacquard guide bar 1, other than the cable 44 on one side of the warp knitting machine, no other cable or the like is present at a vicinity of the knitting portion; thus, a no disturbing is caused in operation and knitting on the knitting machine.

Next, it will be explained how to control straining and deforming of the piezoelectric transducer element 5. As described above, the pattern data and signals inputted to the control computer 37 are processed by the control computer 37; and control signals and drive current are transmitted to each ones of the control boards 12 for respective knitting courses, through the data output card 41, through the line driver board 38 and the receiving board 39 and then though the cable. Then, when electricity at 48V is applied to the displacing section 7 of the piezoelectric transducer element 5, the piezoelectric ceramics 7b, 7b are strained and the displacing section 7 is deflected. Thereby, the jacquard guide 8b is displaced to move at inside of the recessed or groove portion 24 to the left side or to the right side until being brought into contact with a stop position and by pertinently repeating the displacement, patterned knitting is carried out.

The above-described control of deflecting the piezoelectric transducer element 5 is preferably made as follows by utilizing a way to control electricity application to the piezoelectric transducer element according to a second embodiment, mentioned later. The two piezoelectric ceramics 7b, 7b are deliberately deformed simultaneously in a same direction by applying electricity to the piezoelectric ceramics on both sides, as to polarize the ceramics 7b, 7b on the both sides as heteropolar between said both sides.

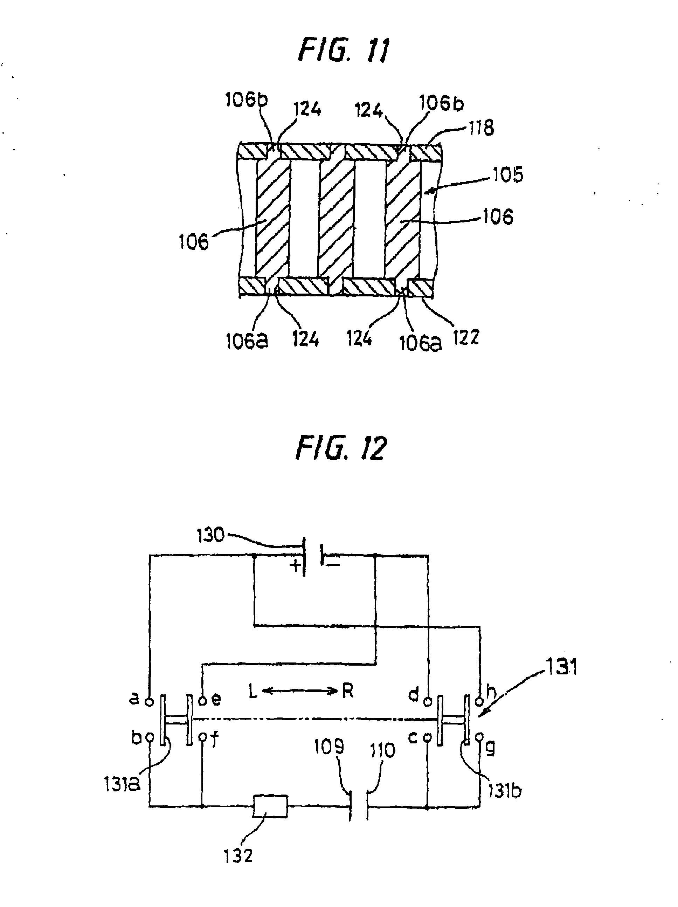

That is, electricity is applied to the piezoelectric ceramics 7b, 7b by utilizing a changeover switch shown in Fig. 12 in a circuit of the control board 12; so as to polarize the piezoelectric ceramics 7b, 7b as one side thereof be positive (+) and other side thereof be negative (-); in such a manner that the two piezoelectric ceramics 7b, 7b are deliberately deflected simultaneously in the same direction. Thereby, a displacement necessary and sufficient may be produced even at low voltage, to the jacquard guide; thus, concern of a hazard by electricity leakage or the like is reduced; and further, durability of the piezoelectric transducer element per se or the IC chip is enhanced.

According to the above-described apparatus of the first embodiment, the control board 12 for controlling the piezoelectric transducer element 5 is integrally provided at the jacquard segment 2; and thereby, attaching members and cords, which are in the conventional apparatus, may be completely eliminated from a vicinity of the knitting portion of the knitting machine. Therefore, there is created an environment preferable for knitting operation and in dealing with the knitting machine.

Further, only a single piece of the cord at the respective jacquard guide bar will do because of follows; the control boards on the respective segments are serially connected by cords each having the bus lines at input and output connectors on the segments; thus enabling serial transmittance of the controlling and driving signals. As a result, provision of a plurality of sheets of the jacquard guide bars is extremely facilitated, which can contribute to large number formation of the jacquard guide bars.

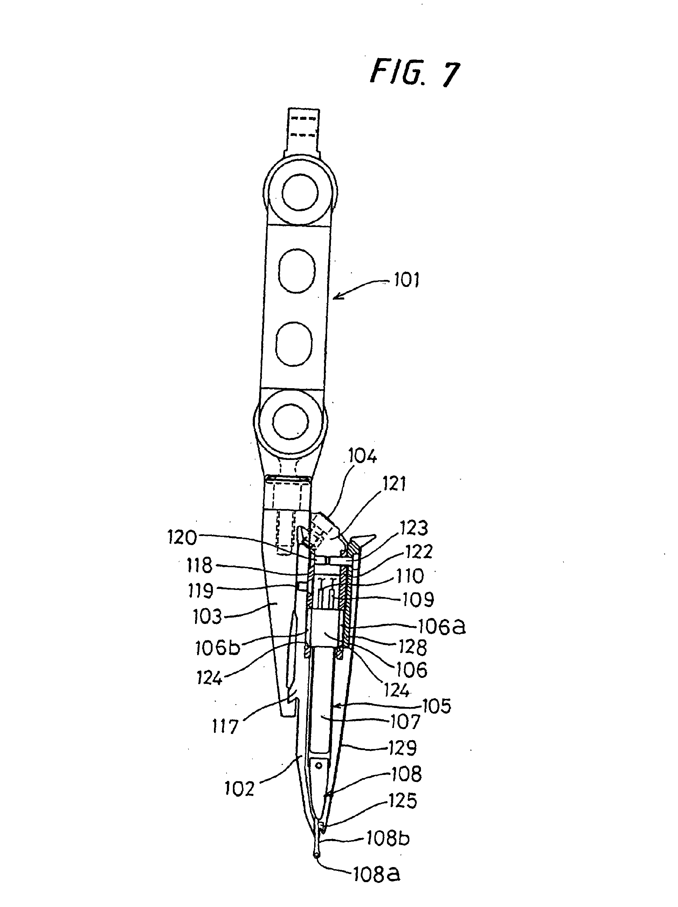

Next, an explanation will be given of a second embodiment of the invention-wise apparatus in reference to Fig. 7 through Fig. 12. Fig. 7 is a partially sectional side view showing an embodiment of a jacquard guide structure of the invention-wise apparatus having a piezoelectric actuator.

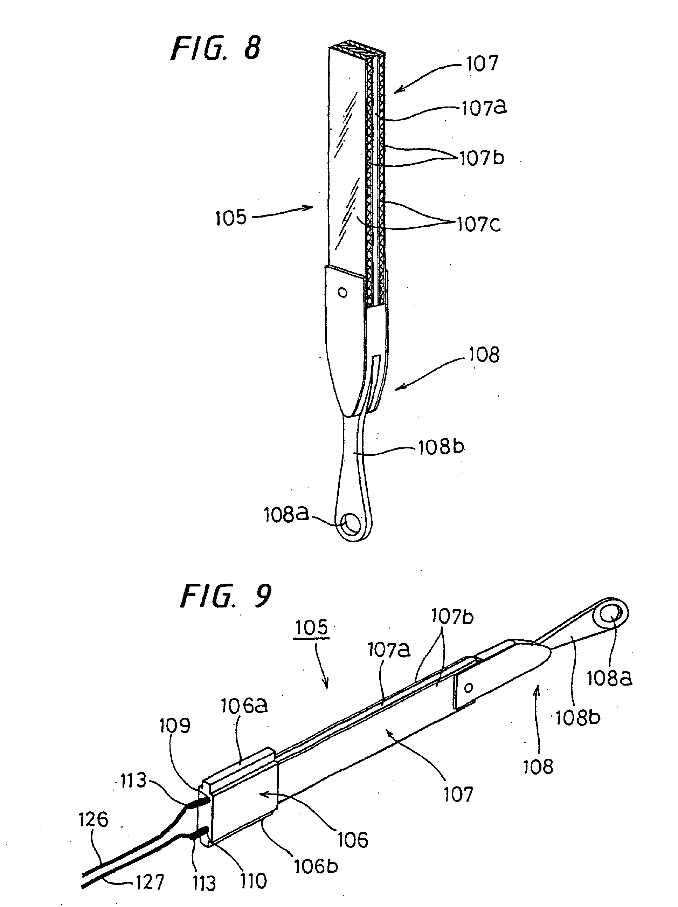

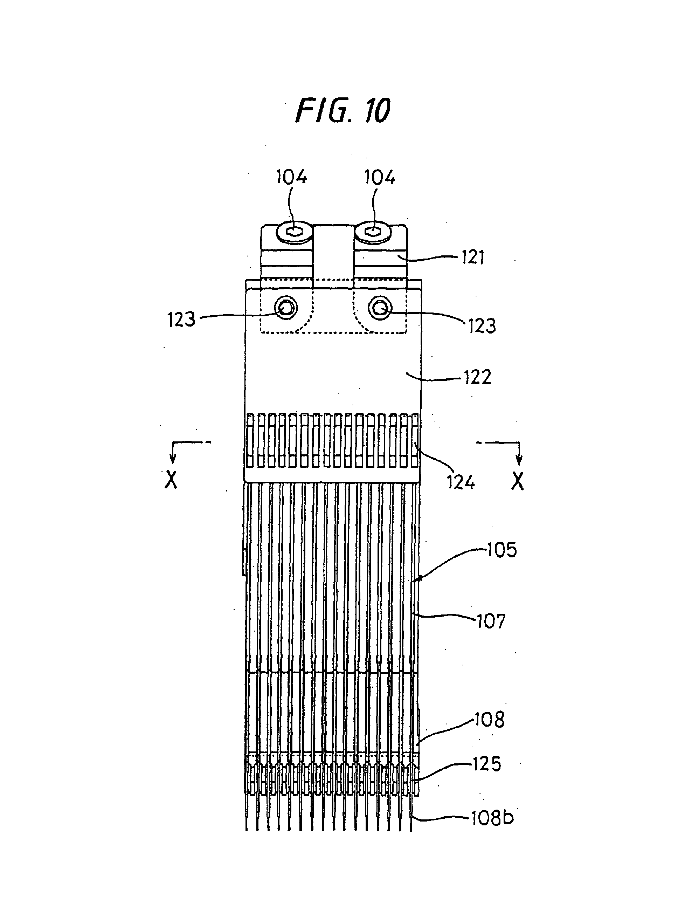

In the drawing, numeral 101 designates a jacquard guide bar; and a jacquard segment 102 is fixed to a mounting part 103 provided at one end portion of the jacquard guide bar 101 by a screw 104. Numeral 105 designates a piezoelectric transducer element, which is comprised of a holder section 106, a displacing section 107 and a guide section 108, as shown by Fig. 9 and Fig. 10. A detailed explanation will be given thereof as follows.

Notation 107a designates a support thin plate having a thickness of 0.1mm. Piezoelectric ceramics 107b, 107b each having a thickness of 0. 2mm formed by coating an electrode layer by silver plating, are adhered to both faces of the support thin plate 107a to thereby constitute the displacing section 107 having a thickness of 0. 5mm. Notation 107c designates thin films for insulation coated on outer sides of the electrode layers of the piezoelectric ceramics 107b. 107b.

The holder section 106 is fixedly provided to one end portion of the support thin plate 107a of the displacing section 107 by injection molding. Numeral 109 designates one electric terminal formed by extending one end portion of the support thin plate 107a. Numeral 110 designates other electric terminal, which is fixed to the holder section 106 by integral molding, and which enables applying of electricity to the electric terminal layers of the piezoelectric ceramics 107b, 107b.

The guide section 108 is formed by attaching a jacquard guide 108b having a string feed hole 108a, which is for guiding a string at one end portion thereof at an end portion of the displacing section 107 on a side opposed to the holder section 106.

As described above, the piezoelectric transducer element 105 is constituted by integrating the displacing section 107, the holder section 106 and the guide section 108. The piezoelectric transducer element 105 functions as a piezoelectric actuator; when electricity is applied to the piezoelectric ceramics, the displacing section 107 is strained as deflected by the piezoelectric effect; and when the electricity is ceased to be applied, the displacing section 107 returns to its original position; in this way, the jacquard guide 108b is brought to be shifted to a desired direction.

Fig. 10 is a front view showing one unit of the jacquard segments 102 in which, for example, 16 pieces of the piezoelectric transducer elements 105 are arranged side by side, at constant intervals in correspondence with a needle row (not illustrated) of the warp knitting machine, in a manner that each of the piezoelectric transducer elements 105 is detachable and attachable separately with each other.

Next, an explanation will be given of an embodiment of a jacquard guide structure for enabling to attach and detach the piezoelectric transducer element 105 in reference to Fig. 7, Fig. 9, Fig. 10 and Fig. 11.

Numeral 117 designates an attaching frame for being tightly attached to the mounting part 103; an upper portion of the attaching frame 117 is screwed with a holding plate 118 by a screw 119 and is screwed with a holding member 121 by a screw 120. Numeral 122 designates a holding plate, which is provided on a side opposed to the holding plate 118 with the holding member 121 therebetween; the holding plate 122 is constructed to be screwed to the holding member 121, along with a lid plate 128, by screws 123, 123.

Numeral 129 designates a protection plate which is provided over several pieces of the segments 102 and in which an upper end thereof is detachably attached to the lid plate 128 and a lower end thereof is detachably attached to an end of a the recessed or groove portion 125. As explained also in the above-described first embodiment in reference to Fig. 4, the recessed or groove portion 125 is provided to a lower end of the attaching frame 117 by being cut in correspondence with the knitting machine gage and the jacquard guide 108b is continuously fitted into the groove portion 125 and provided to be able to displace in the left and right direction within a groove width thereof.

The holding plates 118 and 122 are respectively inscribed with 16 pieces of positioning groove portions 124 at constant intervals in correspondence with the knitting machine gage. As shown by Fig. 10 and Fig. 11, the piezoelectric transducer elements 105 are respectively positioned by fitting projected streaks 106a and 106b provided on both sides of the holder sections 106 to the positioning groove portions 124 of the holding plates 118 and 122, are held to be arranged side by side at constant intervals and attached to the jacquard segment 102. That is, one unit of the jacquard segment 102 has 16 pieces of the piezoelectric transducer elements 105 arranged side by side. Depending on the gage of the knitting machine, one unit of the segment may be formed of 32 pieces of the piezoelectric transducer elements 105 arranged side by side.

The electric terminals 109 and 110 are connected with electrode lines 126 and 127. via plugs 113, 113 with electrode lines are summarized, further summarized into a single piece of cord along with the electrode lines of the other elements and plugged in a control output portion (not illustrated) disposed above the attaching frame 117 horizontally suspended in the width direction of the knitting machine and integrated with a control board and connected to the control board.

The above described is the constitution of the jacquard apparatus according to the second embodiment; and an explanation will be given of a system of controlling to apply electricity to the piezoelectric transducer element 105 in reference to Fig. 7, Fig. 9, Fig. 10 and Fig. 12.

Fig. 12 is to facilitate to grasp a circuit in the control board. Numeral 130 designates a direct current power source for applying control voltage to the element 105, which is set to 48V according to the embodiment. Numeral 131 designates a changeover switch for switching a direction of current, the changeover switch 131 is provided with cooperatively moved switch portions 131a and 131b; and application of electricity to the piezoelectric ceramics 107a and 107b on both sides of the piezoelectric transducer element 105 can be switched. Numeral 132 designates a current restricting resistor for preventing overcurrent when the circuit is short-circuited; and a resistor of 22KΩ is adopted.

For displacing the jacquard guide 108b, first, for moving the jacquard guide 108b to one side, by operating the changeover switch 131 to an L side, contact points "a" and "b" and contact points "c" and "d" are closed; as aresult, the electric terminal 109 becomes positive (+) and the electric terminal 110 becomes negative (-) to apply necessary voltage on the displacing section 107; thereby, the polarized piezoelectric ceramics on both sides are deliberately or intentionally deflected, simultaneously in the same direction; a predetermined displacement toward one side is brought about in the jacquard guide 108b; and lapping is carried out. Further, when to move the jacquard guide 108b toward other side, by operating the changeover switch 131 to an R side, the contact points "a" and "b" are opened and contacts "e" and "f" are closed, simultaneously; the contact points "c" and "d" are opened and contact points "g" and "h" are closed; thereby, the electric terminal 109 becomes negative (-), the electric terminal 110 becomes positive (+); the piezoelectric ceramics on the both sides are deliberately strained in a direction reverse to the above-described simultaneously; the jacquard guide 108b is displaced toward the other side and thereby lapping is carried out.

Although according to the above-described embodiment, the control voltage is set to 48V, by selecting desired voltage in a range of 40V through 100V in correspondence with a moving amount of the jacquard guide 108b in accordance with coarseness and denseness of the knitting machine gage, pertinent lapping is carried out.

Further, when a single piezoelectric portion of the piezoelectric transducer element 105 is damaged, the holding plate 118 is removed by loosening the screws 123, 123; the electrode lines 126 and 127 are drawn out from the electric terminals 109 and 110; the holder section 106 is picked up and drawn out slowly in the forward direction; a new one of the piezoelectric transducer element is fitted in an order reverse to the above-described; the electrode lines are plugged in the predetermined electric terminals; and thereafter, the holding plate is attached and the screws are tightened to thereby finish detaching operation.

According to the second embodiment, the displacing section, which is formed by providing the piezoelectric ceramics on the both sides of the piezoelectric element, is constructed such that electricity is applied to the piezoelectric ceramics on the both sides as to be polarized to be positive (+) on one side and be negative (-) on other side; to thereby deliberately deflect the two piezoelectric ceramics simultaneously as to thereby deflect the two piezoelectric ceramics in the same direction; and the guide is made to carry out lapping. Therefore, control at low voltage can be carried out; as a result, concern of a hazard by electricity leakage or the like is reduced, which can contribute also to enhancing of the durability of the piezoelectric transducer element per se.

Further, by pertinently selecting conducted voltage between 40V and 100V, danger by electricity leakage or the like is avoided; and safe operation of the knitting machine can be carried out.

Further, preferably, even when a single piece of the piezoelectric transducer element is damaged, the element can easily be detached and attached separately with each other; and thus making convenient in handling and maintenance of the knitting machine.

Further, the system of controlling to conduct electricity to the piezoelectric transducer element according to the second embodiment is not only applicable to warping control of the apparatus according to the first embodiment but also can be carried out naturally in warping control of a jacquard apparatus of a warp knitting machine constituted by arranging the above-described piezoelectric transducer element to a jacquard guide bar in correspondence with a needle row.

### [Industrial Applicability]

The jacquard apparatus in the warping knitting machine of the invention, as the apparatus of individually controlling the jacquard guide by utilizing the piezoelectric transducer, not only facilitates fabrication and knitting operation of the jacquard guide bar but also can realize the concise jacquard guide structure, thereby can be utilized preferably in the warp knitting machine installed with a number of sheets of the jacquard guide bars.

Further, the second jacquard apparatus of the invention is provided with the structure enabling to strain or deflect the piezoelectric transducer element sufficiently by comparatively low voltage of, for example, about 40V but also the structure in which the piezoelectric transducer element can individually be detached and attached and therefore, the second jacquard apparatus can preferably be utilized in the warp knitting machine installed with a number of sheets of the jacquard guide bars.

## Claims

1. A jacquard apparatus in a warp knitting machine comprising: piezoelectric actuators; jacquard segments, each of which has piezoelectric transducer elements arranged side by side, as each of the transducer elements has a jacquard guide having a string feed hole at one end of the jacquard guide; and a jacquard guide bar, on which a plurality of said jacquard segments are attached;
said jacquard apparatus being **characterized by** comprising:
controller boards that are connected with each other in serial, each being integrally incorporated in a portion of respective one of the jacquard segments, and each being electrically connected separately with other to electric terminals on respective ones of the piezoelectric transducer elements;
wherein each of the piezoelectric transducer elements on the jacquard segments, which are arranged side by side, is deflectable in response of a controlling and driving signal transmitted to respective one of said controller boards.

2. A jacquard apparatus in a warp knitting machine according to Claim 1,
wherein each of the jacquard segments, which is a unit formed of piezoelectric transducer elements arranged side by side with each other, is fixed on a mounting part on the jacquard guide bar as to be arranged contiguous with other in a longitudinal direction of the jacquard guide bar; and
said jacquard segments being connected with each other through cables formed of bus lines, as input and output connectors on upper portions of the jacquard segments being connected by the cables.

3. A jacquard apparatus in a warp knitting machine according to Claim 1 or 2,
wherein the jacquard segment has a plurality of the piezoelectric transducer elements that are arranged side by side and are attached thereon by fitting separately with each other.

4. A jacquard apparatus in a warp knitting machine according to Claim 1 or 2,
wherein said piezoelectric transducer element has a deflector section formed of piezoelectric ceramics on both sides thereof; and said piezoelectric ceramics on both sides being deliberately deformed simultaneously in a same direction when electricity is applied to the piezoelectric ceramics on both side as to be polarized as heteropolar between said both sides.

5. A jacquard apparatus in a warp knitting machine comprised of piezoelectric transducer elements, each of which has a piezoelectric actuator and a jacquard guide having a string feed hole at one end portion of the jacquard guide; and the piezoelectric transducer elements being arranged on a jacquard guide bar as to match a row of knitting needles;
said jacquard apparatus being **characterized by** said piezoelectric transducer element that is comprised of;
a displacing section formed of piezoelectric ceramics adhered on both faces of a thin supporter plate and provided with electrode layers;
a holder section secured on an end portion of the displacing section;
and a guide section formed of a jacquard guide having a string-feeding hole at its end opposite to the displacing section; and
said piezoelectric ceramics on both sides being deliberately deformed simultaneously in a same direction when electricity is applied to the piezoelectric ceramics on both side as to be polarized as heteropolar between said both sides; as thereby lapping of the jacquard guide being effected.

6. A jacquard apparatus in a warp knitting machine according to Claim 5, wherein feeding of strings, which is based on a displacement of a front end of the guide, is enabled by applying a voltage in a range of 40V through 100V onto the piezoelectric transducer element, which has the jacquard guide.

7. A jacquard apparatus in a warp knitting machine according to Claim 5,
wherein each of the piezoelectric transducer elements, which is fabricated separately with each other, has; an electric terminal integrally formed on the holder section at one end of the piezoelectric transducer element; and ridges on both side ends of the holder section as to be fitted in positioning grooves on detachably-mounting parts on the guide bar; thereby each of the jacquard guide is attachable and detachable separately with each other.
